# EUROPÄISCHE PATENTSCHRIFT

(11) **EP 2 735 018 B1**
(45) Veröffentlichungstag und Bekanntmachung des Hinweises auf die Patenterteilung: **19.10.2016**
(21) Anmeldenummer: 12737303.3
(22) Anmeldetag: 23.07.2012
(51) Int. Cl.: H01J 37/34, C23C 14/35, C23C 14/50, C23C 14/56

(54) **VERFAHREN UND VORRICHTUNG ZUR HERSTELLUNG PARTIKELARMER SCHICHTEN AUF SUBSTRATEN**
METHOD AND DEVICE FOR PRODUCING LOW-PARTICLE LAYERS ON SUBSTRATES
PROCÉDÉ ET DISPOSITIF DE FABRICATION DE COUCHES PAUVRES EN PARTICULES SUR DES SUBSTRATS

(30) Priorität: 21.07.2011 EP 11174871
(43) Veröffentlichungstag der Anmeldung: 28.05.2014
(73) Patentinhaber: Fraunhofer Gesellschaft zur Förderung der angewandten Forschung E.V., 80686 München (DE)
(72) Erfinder: VERGÖHL, Michael, 38162 Cremlingen (DE); RADEMACHER, Daniel, 38110 Braunschweig (DE); KRICHELDORF, Hans-Ulrich, 38667 Bad Harzburg (DE); BRÄUER, Günter, 38162 Cremlingen (DE)
(74) Vertreter: Pfenning, Meinig & Partner mbB
(86) Internationale Anmeldenummer: PCT/EP2012/064404
(87) Internationale Veröffentlichungsnummer: WO 2013/011149

(56) Entgegenhaltungen:
- DE-A1-102007 016 029
- US-A1- 2009 065 741
- US-B2- 7 923 114
- M Vergöhl ET AL: "Particle generation during reactive magnetron sputtering of SiO2 with cylindrical and planar cathodes", Optical Interference Coatings (OIC) OSA Technical Digest (Optical Society of America, 2010), paper TuD3, 6. Oktober 2010 (2010-10-06), XP055013070, Tucson, Az, USA Gefunden im Internet: URL:http://www.opticsinfobase.org/DirectPD FAccess/5E68BA4A-F06B-71E3-BB4D27F64F38382 C_202399.pdf?da=1&id=202399&uri=OIC-2010-T uD3&seq=0&mobile=no [gefunden am 2011-11-24]
- DANIEL RADEMACHER ET AL: "New sputtering concept for optical precision coatings", PROCEEDINGS OF SPIE, 3. Oktober 2011 (2011-10-03), Seiten 81680O-81680O-7, XP055013232, ISSN: 0277-786X, DOI: 10.1117/12.896843

## Beschreibung

Die Erfindung bezieht sich auf Verfahren und Vorrichtungen zur Herstellung einer oder mehrerer partikelarmer Schichten auf Substraten im Vakuum. Die Schichten werden aus zylindrischem Quellmaterial, optional zusammen mit einer Reaktivgaskomponente, durch Magnetron-Sputtering auf das Substrat aufgebracht. Das Aufbringen der Schicht erfolgt entgegen der Schwerkraft in einem sogenannten "Sputter-up"-Verfahren. Innerhalb des Verfahrens bzw. der Vorrichtung können die Schichten optional durch eine Plasmaquelle in ihrer Struktur bzw. stöchiometrischen, atomaren Zusammensetzung modifiziert werden. In der Vorrichtung können mehrere Sputterquellen mit verschiedenen Quellmaterialien vorgesehen sein, so dass sich in einem Prozess in hoher Geschwindigkeit mehrere Schichten unterschiedlicher Zusammensetzung auf dem Substrat aufbringen lassen.

Optische Präzisionsfilter sind eine Schlüsselkomponente vieler industrieller Produkte der optischen Technologien. Anwendungen reichen von der Lasertechnik über Medizin- und Bioverfahrenstechnik, Display- und Automobil- bis zur Solarindustrie. Bedingt durch die stetig steigenden technologischen Anforderungen sowie durch die zunehmende Konkurrenz aus Billiglohnländern wächst die Nachfrage nach besseren, flexibleren und zugleich wirtschaftlichen Produktionsverfahren für optische Präzisionsbeschichtungen. Heutige Verfahren kommen zunehmend an technologische Grenzen bei besonders hohen Anforderungen: Steigender Ausschuss, zu geringe Langzeitstabilität sowie die Nicht-Realisierbarkeit von technischen Spezifikationen mindert die Wirtschaftlichkeit und behindert die Einführung neuer Produkte.

Optische Dünnschichtsysteme, die das Prinzip der Interferenz nutzen, z.B. für die Lasertechnik, Medizin- und Bioverfahrenstechnik, Display- und Automobiltechnik bis zur Solarindustrie, erfordern hierbei das möglichst präzise Einhalten der spezifizierten Filtereigenschaften sowie geringe Absorptionen und Verluste im optischen Filter. Um insbesondere die geforderten minimalen Verluste einzuhalten, ist es unabdingbar, die Kontamination der Oberflächen mit Partikeln zu minimieren, da diese die Ursache für Streuung, Absorption und geringe Zerstörschwellen sein können (z.B. im Bereich der Laseranwendungen).

Die zu erreichenden Schichteigenschaften erfordern dabei oft einander widersprechende Prozessbedingungen. So korreliert eine hohe Schichthärte und stabile Beschichtung mit sehr glatter Oberfläche (ohne Temperaturabhängigkeit der Kanten) in der Regel mit kompressiven Schichtspannungen, während Schichten ohne Stress meist rau sind und eine starke Temperatur- und Feuchteabhängigkeit (spektraler Shift) zeigen.

Frühzeitig erkannte man die große Bedeutung des Zusammenhanges von energetischen Teilchen (Ionen, Neutralteilchen, Radikale) mit dem Schichtwachstumsprozess und somit den Schichteigenschaften: Die Morphologie und damit auch die Schichteigenschaften in Plasma-Beschichtungsprozessen sind wesentlich durch die Art und die Energieverteilung sowohl von Ionen als auch von Neutralteilchen bestimmt, wobei die Teilchenenergien von Ionen und Neutralteilchen je nach Plasmabedingungen stark variieren können.

Auch die optischen Eigenschaften werden durch das Teilchen-Bombardement (z.B. mit Sputtergasteilchen) der wachsenden Schicht beeinflusst. Beispielsweise bewirkt der Einbau von Argon in oxidische oder fluoridische Schichten eine erhöhte Absorption.

Die Möglichkeit der Beeinflussung der Ionen- und Neutralteilchenenergien und deren Dichte sind von hohem Interesse für die Herstellung und Optimierung optischer Schichten. Energetische Neutralteilchen, die auf die wachsende Schicht treffen, können beispielsweise Frenkel-Defekte induzieren (Hisashi Arakaki, Kazutoshi Ohashi und Tomoko Sudou, "Sputter-induced defects in zn-doped GaAs Schottky diodes", Semicond. Sci. Technol. 19, Nr. 1 (Januar 2004), S. 127-132). Nanodefekte spielen eine immer größere Rolle bei Hochleistungsoptiken für Ultrakurzpuls- oder UV-Laseranwendungen.

Die US 5,525,199, (Corning OCA; "Reactive magnetron sputtering apparatus and method") beschreibt ein Sputtering-Verfahren und eine Sputtering-Vorrichtung unter Vakuum mit einem Prozessdruck von 5·10⁻⁵ - 1.5·10⁻⁴ Torr (= 6.7·10⁻⁵ - 2.0·10⁻⁴ mbar). Der Abstand von Target zu Substrat beträgt 16 inch (= 40 cm).

Gleiches gilt für die US 5,851,365 (Corning OCA; "Low pressure reactive magnetron sputtering and method"), welche eine ähnliche Vorrichtung und ein ähnliches Verfahren beschreibt. Der Prozessdruckbereich dieser Vorrichtung befindet sich zwischen 5·10⁻⁵ - 4.2·10⁻⁴ Torr (= 6.7·10⁻⁵ - 5.6·10⁻⁴ mbar). Der Abstand zum Target ist ebenfalls 16 inch.

Bei der Regelung der Prozesse nach dem Stand der Technik ist eine Zeitkonstante von etwa 20 bis 30 Millisekunden erreichbar.

Ein Nachteil dieser dynamischen Stabilisierung ist, dass selbst bei optimaler Regelung geringe Restschwankungen der Prozessbedingungen und damit auch der Stöchiometrie der Schicht nicht zu vermeiden sind, die zu geringen Inhomogenitäten und damit zu Verlustmechanismen führen können. Diese Inhomogenitäten können beispielsweise einen optischen Verlust (z.B. Verlust der Intensität), Abweichungen in der Dispersion und/oder Abweichungen in der Absorption hervorrufen. Besonders bei sehr hochwertigen optischen Schichten bereiten solche Inhomogenitäten gravierende Probleme.

Daher wird im Stand der Technik auch der Ansatz des Sputterns von sehr dünnen, substöchiometrischen oder metallischen Schichten betrieben, die separat in einem Sauerstoffplasma nachoxidiert werden. Der Vorteil bei dieser Methodik liegt ebenfalls in der weitgehend metallischen Oberfläche des Targets. Dieses Herstellungsverfahren bedingt eine Anlagentechnik mit separater Plasmaquelle und einer Substratbewegung im Prozess (Scherer, M., J. Pistner, et al. (2004), "Innovative Production of High Quality Optical Coatings for Applications in Optics and Optoelectronics", 47th Annual Technical Conference Proceedings of the Society of Vacuum Coaters, 179, 2004). Jeweils sehr dünne Schichten (1-2 Ǻ) werden dabei oxidiert.

Für dieses Verfahren eignen sich insbesondere Drehtelleranlagen, wie in der DE 103 47 521 A1 beschrieben, da hier die Stationen für die Beschichtung und die Station für die Nachoxidation nacheinander angefahren werden können. Die Vorrichtung und das Verfahren aus der DE 103 47 521 A1 sind für ein "sputterdown" vorgesehen. In dieser Anordnung wird Quellmaterial mit der Schwerkraft von oben nach unten auf Substrat abgeschieden. Der Teilchenstrom ist im Wesentlichen durch den Anfangsimpuls, Stöße und Diffusion der Teilchen aus Quellmaterial gekennzeichnet. Je schwerer die Teilchen sind, desto stärker wirkt sich die Gravitationskraft auf die Teilchen aus. Im "sputter down"-Verfahren werden schwere Teilchen (Partikel) verstärkt durch die Gravitation auf das Substrat beschleunigt. Ein Nachteil des "sputter down"-Verfahrens besteht folglich darin, dass Partikel durch die Gravitation in Richtung Substrat beschleunigt und nicht vom Substrat weg beschleunigt werden. Somit können im "sputter down"-Verfahren Partikel ungehindert auf das Substrat gelangen. Der Einfluss der Partikel auf die Qualität des Produkts wird hierbei vernachlässigt.

Die Frage von Partikeln in Beschichtungsprozessen ist jedoch von hoher praktischer Bedeutung. Partikel oder auch allgemein Defekte auf dem Substrat degradieren die Beschichtung und führen in der Regel zu Ausschuss. Diese Frage wird im Zuge der wachsenden Anforderungen und steigender Miniaturisierung immer wichtiger.

Vergöhl et al. (Optical Interference Coatings (OIC) OSA Technical Digest, Optical Society of America, 2010, paper TuD3, 06.10.2010) offenbart ein Magnetron-basiertes Verfahren und eine entsprechende Vorrichtung zur Herstellung von Schichten auf bewegten Substraten, wobei ein zylindrisches Target eingesetzt wird.

US 2009/065741 A1 offenbart ein Magnetron-basiertes Verfahren und eine entsprechende Vorrichtung zur Herstellung einer Schicht einer organischen Elektrolumineszenz-Vorrichtung.

US 7 923 114 B2 offenbart Sputtering-Verfahren zur Abscheidung eines Mischoxid-Films, der Siliziumdioxid und Titandioxid enthält, wobei in dem Verfahren ein Target aus Silizium und ein Target aus Titan eingesetzt wird.

Rademacher et al. (Proceedings of Spie, 03.10.2011, S. 816800-816800-7) offenbart ein Doppelmagnetronbasiertes Verfahren und eine entsprechende Vorrichtung zur Herstellung von Schichten auf bewegten Substraten, wobei ein zylindrisches Target verwendet wird und in einer "sputter-up"-Konfiguration abgeschieden wird.

Es war daher Aufgabe der vorliegenden Erfindung, ein verbessertes Verfahren und eine verbesserte Vorrichtung zur Beschichtung von Substraten bereitzustellen.

Diese Aufgabe ist durch das Verfahren mit den Merkmalen des Anspruchs 1 und die Vorrichtung mit den Merkmalen des Anspruchs 7 gelöst. Die weiteren abhängigen Ansprüche zeigen vorteilhafte Weiterbildungen.

Erfindungsgemäß wird ein Verfahren zur Herstellung partikelarmer Schichten auf bewegten Substraten in einer Vakuumkammer mittels mindestens einer Magnetron-Sputtereinrichtung bereitgestellt, wobei die Schichten aus zylindrischem Quellmaterial, optional zusammen mit einer Komponente aus Reaktivgas, gebildet werden, bei dem folgende Schritte vorgesehen sind:
- Immobilisieren des Substrates mittels einer Substrathalterung auf einem Drehteller;
- Abscheiden mindestens einer Schicht aus Quellmaterial mit Sputtergas, optional zusammen mit einer Komponente aus Reaktivgas, auf dem Substrat in mindestens einer Magnetron-Sputtereinrichtung;
wobei der Drehteller rotiert, so dass eine Magnetron-Sputtereinrichtung angesteuert werden kann und das zylindrische Quellmaterial entgegen der Schwerkraft (d.h. nach oben) auf das Substrat abgeschieden wird.

In dem erfindungsgemäßen Verfahren kann mindestens eine Plasmaquelle Verwendung finden. Die Plasmaquelle kann über Plasmaeinwirkung die Oberfläche des Substrates, optional zusammen mit Reaktivgas, vorbehandeln (z.B. Reinigung der Oberfläche). Optional kann die Struktur und/oder die Stöchiometrie der Schicht über Plasmaeinwirkung einer Plasmaquelle, optional zusammen mit Reaktivgas, modifiziert werden.

Falls mindestens eine Plasmaquelle in einer bevorzugten Ausführungsform des Verfahrens Verwendung findet kann die mindestens eine Plasmaquelle mit dem Drehteller angesteuert werden.

Magnetron-Sputterquellen haben sich in den letzten Jahren als äußerst leistungsfähige Beschichtungswerkzeuge erwiesen, um Dünnschichtsysteme im industriellen Maßstab zu fertigen.

In dem erfindungsgemäßen Verfahren werden Magnetron-Sputterquellen mit zylindrischem Quellmaterial verwendet. Zylindrisches Quellmaterial (= zylindrische Targets), bevorzugt in Form einer zylindrischen Elektrode, sind insbesondere für optische Beschichtungen und den damit verbundenen Ansprüchen an Schichthomogenität und Partikelfreiheit vorteilhaft.

Bei zylindrischen Quellen liegt nicht das Problem von planaren Targets vor, dass sich ein Erosionsgraben an der Oberfläche der Targets ausbildet, der zu einer Veränderung der Schichtdickenverteilung führt. Prinzipiell kann durch zylindrische Quellen eine ideale Schichtdickenverteilung über die gesamte Targetlebensdauer eingehalten werden. Zusätzlich ist der Durchsatz bei zylindrischen Quellen gegenüber planaren Quellen erhöht und der Prozess weist eine höhere Langzeitstabilität auf.

Die Magnetron-Sputterquellen werden in einer sogenannten "sputter-up" Anordnung eingesetzt. "Sputterup" bedeutet, dass das zylindrische Quellmaterial entgegen der Gravitation d.h. nach oben (auf das Substrat) abgeschieden wird. Der Vorteil dieses Verfahrens besteht darin, dass sich auf schwere Teilchen (Partikel) die Gravitationskraft stärker auswirkt als auf leichte Teilchen. Folglich werden schwere Teilchen stärker in Richtung der Gravitationskraft d.h. nach unten beschleunigt. Dadurch werden die Partikel von dem Substrat weg beschleunigt und werden daran gehindert sich auf dem Target (Substrat) als Störfaktor abzuscheiden.

Durch die "sputter-up"-Anordnung steigt die Produktivität des Beschichtungsprozesses, besonders die Qualität der beschichteten Bauteile wird dadurch gesteigert. Weitere wichtige Gründe für die "sputter-up"-Anordnung mit zylindrischen Magnetron-Elektroden (Targets) sind die Langzeitstabilität des Sputterprozesses und eine Arc-freie Umgebung auf Grund der Abwesenheit von Ladung auf der Oberfläche der Targets. Bei planaren Targets wird durch das Sputtern nur ein Bereich des Targets abgetragen, daneben kommt es zur Redeposition. Auf der abgeschiedenen dielektrischen Schicht kann sich eine Ladung aufstauen bis es zum elektrischen Durchbruch kommt (Arcing). Zylindrische Quellen (Targets) besitzen keine Redepositionszone. Dies hat bei reaktiven Prozessen den weiteren Vorteil, dass sich eine höhere Prozess-Sauberkeit ergibt. Ferner ändert sich durch den homogenen Abtrag eines zylindrischen Targets die Absputtercharakterisik des Targets nicht. Dies macht den Einsatz von Blenden einfacher und die Blenden können über die gesamte Targetlebensdauer eingesetzt werden (höhere Langzeitstabilität).

Planare Targets weisen besonders in der "sputter-up"-Konfiguration gegenüber zylindrischen Targets einen weiteren Nachteil auf. Durch planare Quellmaterialien (Targets) erzeugte Partikel können einen Kurzschluss auslösen indem sie in den Dunkelraum des Targets fallen. Gerade bei Beschichtungskonzepten, die auf Drehtelleranordnungen basieren, würde das die gesamte Charge zerstören. Da zylindrische Quellen keinen Dunkelraum besitzen sind sie in der "sputter-up"-Konfiguration mit Drehtelleranordnung gegenüber planaren Quellen wesentlich bevorzugt.

In dem erfindungsgemäßen Verfahren und der erfindungsgemäßen Vorrichtung wird optional mindestens eine Plasmaquelle zur Behandlung von Substrat eingesetzt. Ein wichtiges Ziel dieser Plasmabehandlung ist eine Vorbehandlung des Substrates vor der eigentlichen Beschichtung durch den sofortigen Abbau organischer Verbindungen auf dem Substrat. Es gilt das Substrat so vorzubehandeln, dass es möglichst frei von Fremdpartikeln ist. Dadurch kann die Qualität der gesputterten Schichten bezüglich Streuung, Absorption und Zerstörschwellen erheblich verbessert werden. Als Folge können durch das erfindungsgemäße Verfahren flache Substrate (z.B. Linsen) mit erheblich verbesserten Eigenschaften bereitgestellt werden. Speziell für Lasersysteme, Kantenfilter, Fluoreszenzfilter, Bandpassfilter, Reflektoren für verschiedene Wellenlängen, Entspiegelung, Vorspiegelung, Cavity-Filter und/oder UV-IR-Cuts ist das erfindungsgemäße Verfahren besonders vorteilhaft.

Bei der Beschichtung von Substrat mit mehreren Schichten kann sich zwischen den Schichten eine Grenzfläche bilden. In dem erfindungsgemäßen Verfahren kann die Grenzfläche mit O₂ übersättigt werden und/oder vollreaktiv eine Schicht abgeschieden werden. Dieses Vorgehen kann verhindern, dass zwischen zwei Schichten eine Grenzfläche entsteht. Desweiteren wird durch die optionale Behandlung mit Plasma eine Reduktion der Größe von Grenzflächen zwischen zwei Schichten angestrebt, an denen sich Mischungen aus den beiden an die Grenzschicht treffenden Materialien ausbilden. Auch die Ausdehnung der Grenzfläche kann durch Einwirkung der Plasmaquelle verhindert werden. Dies vermindert nicht nur optische Verluste sondern garantiert auch eine bessere "Designtreue".

Die Vakuumkammer innerhalb der Magnetron-Sputtereinrichtung weist in dem erfindungsgemäßen Verfahren und/oder in der erfindungsgemäßen Vorrichtung einen Prozessdruck in dem Bereich von 3·10⁻⁴ - 5·10⁻² mbar auf.

In der Magnetron-Sputtereinrichtung wird der Partialdruck des Sputtergases, und optional des Reaktivgases, über einen Generator geregelt bzw. stabilisiert, bevorzugt über Regelung der Generatorleistung, der Generatorspannung und/oder des Generatorstroms.

Der Vorteil dieser Regelung ist, dass in dem erfindungsgemäßen Verfahren keine dielektrische Schicht vom Target abgetragen wird, sondern das Target zu keiner Zeit mit einer dielektrischen Schicht bedeckt ist. Dies kann beispielsweise dadurch realisiert werden, dass metallische Targets im sog. "Transition Mode" betrieben werden. Hier befindet sich das zylindrische Quellmaterial (Target) durch geeignete Regelung des Generators permanent in einem metallischen, oxidfreien Zustand, während im Prozessraum genügend Sauerstoff für die Oxidation der wachsenden Schicht vorhanden ist. Die oben genannten Stellgrößen werden in der Regel auf den Sauerstoffpartialdruck oder die Spannung des Generators oder des Targets realisiert. Damit lässt sich in dem Prozess die Abscheidung stöchiometrischer Schichten mit einer hohen Abscheiderate erreichen, während der störende Einfluss von Partikeln minimiert, d.h. eine hohe Partikelarmut erreicht wird.

Der Drehteller der Vorrichtung kann in dem Verfahren mit einer Geschwindigkeit von 1-500 U·min⁻¹, bevorzugt 150-300 U·min⁻¹, rotieren. Für einen hohen Durchsatz und eine hohe Präzision kann eine schnelle Rotation des Drehtellers im Bereich von 150-300 U·min⁻¹ vorteilhaft sein. Durch die hohen Rotationsgeschwindigkeiten lässt sich eine Zeitkonstante von etwa 500 µs bis einige Millisekunden realisieren.

In einer weiteren Ausführungsform des Verfahrens dient die Plasmaquelle dazu, Schichtstress in einer Schicht auf dem Substrat zu reduzieren, bevorzugt durch Minimierung der Grenzschichtdicke und/oder Minimierung der Grenzschichtausdehnung zwischen einzelnen Schichten auf dem Substrat.

Schichtstress bzw. Schichtspannungen lassen sich im Rahmen des "Atomic-Peening-Modells" (Windischmann, H., (1992), "Intrinsic Stress in Sputter-Deposited Thin Films", Critical Reviews in Solid State and Materials Sciences, 17(6), S. 547-596) durch den Beschuss der Schicht mit energetischen Teilchen erklären. Auch negativ geladene Sauerstoff-Ionen, wie sie in Reaktivprozessen besonders auftreten, können das Schichtwachstum erheblich beeinflussen. Die Bedeutung negativer Ionen auf das Schichtwachstum wird in jüngster Zeit zunehmend diskutiert (R. Dodd, S. You, P. Bryant, J. W. Bradley, "Negative Ion Density Measurements in Reactive Magnetron Sputtering", Plasma Process. Polym. 2009, 6, S. 615-619).

Reflektierte Argon-Teilchen wurden als Grund für Schichtstress von Windischmann, H., (1992), "Intrinsic Stress in Sputter-Deposited Thin Films", Critical Reviews in Solid State and Materials Sciences, 17(6), S. 547-596, an AlN-Schichten sowie an BC-Schichten von Jacobsohn erkannt (L. G. Jacobsohn, R. D. Averitt, und M. Nastasi, "The role of trapped Ar atoms in the mechanical properties of boron carbide films deposited by dc-magnetron sputtering, J. Vac. Sci. Technol. A 21(5) (2003), S. 1639). Andere Gase (z.B. das leichtere Krypton statt Argon) führen zwar zu geringeren Spannungen, aber ebenfalls zu geringeren Härten.

In einer weiteren bevorzugten Ausführungsform erfüllt die Plasmaquelle zumindest eine der folgenden Funktionen:
- Einstellen der Temperatur des Substrates;
- Einstellen der Mikrostruktur einer Schicht auf dem Substrat;
- Reinigung des Substrats, bevorzugt durch Abbau organischer Kontaminationen auf dem Substrat;
- Aktivierung der Oberfläche des Substrates und/oder einer Schicht auf dem Substrat.

In dem erfindungsgemäßen Verfahren kann die Dicke der Schicht auf dem Substrat kontrolliert werden durch optisches Transmissionsmonitoring, optional über polarisierte Transmissionsmessungen, optisches Reflexionsmonitoring, optional über polarisierte Reflexionsmessungen, optisches Absorptionsmonitoring, und/oder Einwellenlängenellipsometrie oder Spektralellipsometrie.

Für das Abscheiden bestimmter Schichten ist eine erhöhte Abscheidungstemperatur bzw. Substrattemperatur gefordert. Hierfür ist in einer bevorzugten Ausführungsform der Vorrichtung ein beheizbares Element am Deckel der Vorrichtung angebracht. Bevorzugt wird hierbei die Temperatur des beheizbaren Elements am Deckel der Vorrichtung in Abhängigkeit von der herzustellenden Schicht eingestellt. Die Temperatur kann dabei auch während des Beschichtungsprozesses verändert werden. Um den Anforderungen an eine bestimmte Schicht zu entsprechen, kann die Temperatur des beheizbaren Elements am Deckel auf einen Wert von 50 bis 450 °C temperiert werden. Die Temperatur des Substrates lässt sich dadurch in einem Bereich von Raumtemperatur (ca. 20°C) und 300 °C einstellen. Der Deckel ist von der restlichen Vorrichtung thermisch isoliert.

Die erfindungsgemäße Vorrichtung zur Herstellung partikelarmer Schichten auf mindestens einem bewegten Substrat im Vakuum mittels Magnetronzerstäubung umfasst folgende Merkmale:
- mindestens eine Magnetron-Sputtereinrichtung mit zylindrischem Quellmaterial, einem Generator, Sputtergas und optional Reaktivgas;
- einen Deckel, bevorzugt mit beheizbarem Element; sowie
- einen Drehteller mit mindestens einer Substrathalterung.

Die Vorrichtung ist dadurch gekennzeichnet, dass der Deckel die Vorrichtung gasdicht abschließt und der Drehteller die mindestens eine Magnetron-Sputtereinrichtung gasdicht abschließt. Ferner ist die mindestens eine Magnetron-Sputtereinrichtung so ausgerichtet, dass sie Quellmaterial, optional zusammen mit einer Komponente aus Reaktivgas, entgegen der Schwerkraft in Richtung Substrat abscheidet.

Die Vorrichtung enthält in einer bevorzugten Ausführungsform mindestens eine Plasmaquelle, welche optional Reaktivgas aufweist. In diesem Fall kann die mindestens eine Plasmaquelle durch den Drehteller der Vorrichtung mit einer effektiven Gasraumtrennung für Gase von 1:25, bevorzugt von 1:100 gasdicht abgeschlossen werden. In einer bevorzugten Ausgestaltungsform der Vorrichtung ist der Drehteller oberhalb der Plasmaquelle lokalisiert.

Für die Abscheidung von Quellmaterial entgegen der Schwerkraft in Richtung Substrat ist der Drehteller bevorzugt oberhalb der Magnetron-Sputtereinrichtung und, falls in einer bevorzugten Ausführungsform vorhanden, der Plasmaquelle lokalisiert.

Ferner ist die erfindungsgemäße Vorrichtung dadurch gekennzeichnet, dass die Magnetron-Sputtereinrichtung mindestens eine Magnetron-Elektrode aus Quellmaterial (= Target) umfasst. Die Magnetron-Elektrode enthält ein Target enthaltend oder bestehend aus einem keramischem Material, oder besteht daraus.

Bevorzugt besteht die Magnetron-Elektrode aus einem Target enthaltend oder bestehend aus keramischem Material. Die bereits erwähnten kompressiven Verspannungen in optischen Schichten sind von hoher Bedeutung. Sie führen zu Verbiegungen der Optik oder auch zur Enthaftung der Schicht oder gar zum Bruch des Substrats. Mit keramischen Targets bietet sich in der Optik der Ansatz der Reduzierung der Schichtspannung. Während bei reinen Reaktivprozessen mit metallischen Targets ein Einfluss negativ geladener Sauerstoff-Ionen festzustellen ist, die zu hohen Schichtspannungen führen (J. M. Ngaruiya, "Fundamental Processes in Growth of Reactive DC Magnetron Sputtered Thin Films", Dissertation, RWTH Aachen (2004)), wurde an keramischen Targets (z.B. AZO, Aluminium-dotiertes zinkoxid) ein verstärktes molekulares Sputtern gefunden (F. Richter, T. Welzel, R. Kleinhempel, T. Dunger, T. Knoth, M. Dimer. F. Milde, "Ion energy distributions in AZO magnetron sputtering from planar and rotatable magnetrons", Surface & Coatings Technology 204 (2009), S. 845-849), so dass zu erwarten ist, dass der Energieeintrag optimiert wird und Schichtspannungen zu reduzieren sind.

Die Magnetron-Elektrode kann ein Target enthaltend oder bestehend aus Oxid-haltigem Material enthalten oder daraus bestehen. Oxid-haltige Materialien haben den Vorteil, dass sie eine Sauerstoffquelle bereitstellen. Manchmal wird im Sputterbereich extra Sauerstoff benötigt, beispielsweise weil der Sauerstoff der Plasmaquelle nicht zum Oxidieren ausreicht oder weil höhere Beschichtungsraten erzielt werden sollen. In diesem Fall ist es günstig, den Sauerstoff direkt vom Target d.h. der Magnetron-Elektrode zu nehmen, weil sich damit eine höhere Stabilität verglichen mit einem Target aus Metall und Sauerstoff als Reaktivgas ergibt. Denn normalerweise führt die reaktive Beschichtung von einem metallischen (bzw. Silizium-) Target unter Verwendung von Reaktivgas zu einer Rateninstabilität, wenn nicht der Sauerstoffpartialdruck genau konstant gehalten wird, da die Rate eines metallischen Targets deutlich unterschiedlich sein kann verglichen mit der Rate des entsprechenden Oxids. Hat man das Reaktivgas (Sauerstoff, Stickstoff) im Target enthalten, ist die Rate unabhängig von der Bedeckung mit einer Oxidschicht.

Bevorzugte Oxid-haltige Materialien sind TiOₓ, TaOₓ, NbOₓ, ZrOₓ, ZrOₓ:Y, HfOₓ, AlOₓ, SiOₓ, ZnOₓ, InSnOₓ und/oder SnOₓ, wobei besonders bevorzugt x so gewählt wird, dass das Target gerade noch eine Leitfähigkeit aufweist, zugleich x aber nahe der Stöchiometrie ist.

Der Abstand von Magnetron-Elektrode zu Substrat kann 2 bis 10 cm, bevorzugt 6 bis 8 cm, besonders bevorzugt 7 cm, betragen. Der Vorteil dieses Abstandes ist, dass eine homogene Beschichtung von kleinen Bauteilen mit hoher Dichte und hoher Präzision ermöglicht wird. Bei höheren Abständen von Magnetron-Elektrode zu Substrat sinkt die Präzision des Beschichtungsprozesses.

Zwischen den Begrenzungswänden der Magnetron-Sputtereinrichtung und dem Drehteller ist erfindungsgemäß ein Abstand von 0,1 bis 5 mm, bevorzugt von 1 bis 3 mm, besonders bevorzugt von 2 mm, vorgesehen. Dieser Abstand hat sich als besonders günstig erwiesen, um die Magnetron-Sputtereinrichtung gasdicht zu gestalten, d.h. eine effektive Gasraumtrennung innerhalb der Vorrichtung sicherzustellen.

Die Magnetron-Sputtereinrichtung kann eine Einzelmagnetronanordnung aufweisen. Bevorzugt weist die Magnetron-Sputtereinrichtung eine Doppelmagnetronanordnung auf. Der Vorteil dieser Anordnung ist, dass pro Zeit, welche das Substrat bei der Magnetron-Sputtereinrichtung verbringt, verglichen mit einer Einzelmagnetronanordnung mehr Quellmaterial abgeschieden werden kann. Die Folge ist eine wesentlich höhere Effizienz des Sputtering-Prozesses. Ferner können durch den Einsatz von Doppelmagnetron-Anordnungen mit bipolarer Anregung bessere Langzeitstabilitäten aufgrund der "nichtverschwindenden Anode" und höhere Plasmadichten in Kombination mit dichteren (aber auch stärker verspannten) Schichten gewährleistet werden.

In einigen Fällen kann es vorteilhaft sein, auch andere Entladungen zu verwenden. So eignet sich eine unipolar gepulste Gleichstrom-Leistungsversorgung "DC gepulst" besonders gut dafür, um temperaturempfindliche Substrate wie Polymere zu beschichten. Die Pulsfrequenz liegt auch hier im Mittelfrequenzbereich. Der Grund ist die geringere Ionenenergie und Ionenstromdichte eines gepulsten DC-Plasmas im Vergleich zu einem MF-Plasma.

Es ist auf der anderen Seite bekannt, dass auch mit RF-Entladungen gearbeitet werden kann. Üblich ist die Frequenz 13,56 MHz. Normalerweise werden diese nicht bevorzugt, weil die Kosten für diese Art von Generatoren höher sind. Vorteilhaft ist allerdings, dass das RF Sputtern auch für isolierende Targetmaterialien eingesetzt werden kann. Dies ist z.B. der Fall für SiOₓ, AlOₓ, aber auch andere Oxide, Nitride oder auch fluoridische Targets. Somit könnten beispielsweise MgF₂ oder andere Fluoride gesputtert werden. Daher kann die Prozessstabilität nochmals erhöht werden, da mit stöchiometrischen Targets gearbeitet werden kann. Vorteilhaft ist hierbei, dass die sich bildenden (isolierenden) Rückbeschichtungsbereiche keine Probleme aufgrund von Entladgungen (Arcing) bereiten, die Schichten damit sehr partikelfrei abgeschieden werden können.

Folglich kann die Vorrichtung vorteilhafterweise eine Gleichstromversorgung (DC), gepulste Gleichstromversorgung (DC gepulst), oder eine Vorrichtung zur Erzeugung von HIPIMS, Mittelfrequenz oder RF-Entladungen aufweisen.

In einer weiteren bevorzugten Ausgestaltungsform enthält die Vorrichtung bevorzugt zwei, optional auch drei, Magnetron-Sputtereinrichtungen. Der Vorteil solcher Ausgestaltungen ergibt sich vor allem bei Multilayer-Beschichtungen, d.h. bei der Beschichtung eines Substrates mit mehreren verschiedenen Schichten. In diesem Fall können bei zwei Magnetron-Sputtereinrichtungen Stapel aus zwei Schichtarten generiert werden, welche unterschiedliches Material (Quellmaterial) aufweisen. Folglich ist im Fall von drei Magnetron-Sputtereinrichtungen die Möglichkeit gegeben, Stapel aus drei Arten von Schichten auf das Substrat zu sputtern, welche jeweils unterschiedliches Material aufweisen. Darüber hinaus lassen sich auch Materialmischungen aus den jeweiligen Quellmaterialien herstellen, d.h. gemischte Schichten können abgeschieden werden. Besonders im Bereich der sehr komplexen optischen Multilagenfilter mit mehr als 100 Einzelschichten ist der Einsatz von zwei Magnetron-Sputtereinrichtungen zur Optimierung der Schichteigenschaften sehr vorteilhaft. Je nach Anforderungen (z.B. spezielles Design) können sich auch drei oder mehrere Magnetron-Sputtereinrichtungen als vorteilhaft erweisen.

Die Magnetron-Sputtereinrichtung kann innerhalb des Vakuums eine effektive Gasraumtrennung für Gase von 1:25, besser 1:100, aufweisen. Eine effektive Gasraumtrennung zwischen den Beschichtungsstationen von 1:100 ermöglicht die Herstellung von klar definierten cogesputterten Materialien. Der Grund hierfür ist, dass Edelgas und/oder Reaktivgas einer Magnetron-Sputtereinrichtung daran gehindert wird, in eine weitere Magnetron-Sputtereinrichtung derselben Vorrichtung zu gelangen. Zudem kann durch die effektive Gasraumtrennung die Menge an Edelgas und/oder Reaktivgas präziser auf einem bestimmten vordefinierten Wert eingestellt und/oder konstant gehalten werden.

Plasmen, basierend auf Magnetronentladungen, bestehen in der Regel zu mehr als 99 % aus nicht-ionisierten Teilchen. Diese können hohe Energien aufweisen und tragen daher stark zu Schichtspannungen bei. Sie lassen sich indirekt, beispielsweise durch Veränderung des Magnetfeld-Designs oder durch die Verwendung alternativer Sputtergase beeinflussen. Erfindungsgemäß kann das Sputtergas ein Edelgas enthalten oder daraus bestehen. Bevorzugte Edelgase sind Argon, Neon, Xeon und Krypton. Edelgasmischungen sind auch möglich. Das Reaktivgas kann erfindungsgemäß ein oxidierendes Gas enthalten oder daraus bestehen. Bevorzugte Reaktivgase sind Sauerstoff, Stickstoff, Tetrafluormethan, Octafluorcyclobutan, Kohlendioxid und Fluorwasserstoff. Auch Mischungen dieser Gase können verwendet werden.

Die Vorrichtung enthält bevorzugt ein Photometer und/oder eine Ellipsometrieflansche. Dadurch wird ermöglicht, photometrisch die Dicke der Schicht auf dem Substrat während des Sputtering-Prozesses zu kontrollieren. Dazu kann eine schnelle Breitbandmessung (z.B. von 300-1000 nm) der Transmission oder Reflexion durchgeführt werden. Durch Vergleich mit dem theoretisch zu erwartenden Spektrum kann die Schichtdicke ermittelt und kontrolliert werden. In einigen Fällen kann zusätzlich auch ein Schwingquarz zum Einsatz kommen, beispielsweise bei Kavitätenfiltern, bei denen man bei bestimmten Schichten eine nur geringe Signaländerung der Transmission erwartet.

Alternativ kann auch eine Ellipsometriemessung durchgeführt werden. Diese muss bei einem Einfallswinkel zwischen etwa 55° und 75° Grad zur Normalen, bevorzugt bei 65°durchgeführt werden. Sehr vorteilhaft ist die in-situ Ellipsometrie auch, um die Dispersion des Brechungsindex (und ggf. Absorptionsindex) zu bestimmen, denn diese muss bei der Breitbandmonitorierung mit Transmission oder Reflexionsmessung genau bekannt sein. Bei der in-situ Ellipsometermessung reicht es oftmals auch aus, diese im statischen Zustand einzusetzen, d.h. bei angehaltenem Drehteller, um die jeweils abgeschiedene fertige Schicht zu vermessen. Die Methode ist daher zur Kalibrierung geeignet.

Oftmals müssen Bauelemente realisiert werden, die eine Polarisationswirkung ausüben. Hierbei werden beispielsweise Vorgaben für Reflexion oder Transmission für polarisiertes Licht gemacht. Tp und Ts sind hierbei die parallel bzw. senkrecht zur Einfallsebene polarisierten Komponente der Transmission, Rp und Rs die parallel bzw. senkrecht zur Einfallsebene polarisierten Komponenten der Reflexion. Diese Bauelemente können somit bei schräger Inzidenz (z.B. 45°, 60°, ...) in die erfindungsgemäße Vorrichtung eingesetzt werden.

Für die Herstellung von Beschichtungen, die unter einem schrägen Einfallswinkel arbeiten sollen, ist es vorteilhaft, wenn die Monitorierung der Schicht ebenfalls unter schrägem Einfallswinkel erfolgt. Um eine schnelle Messung durchzuführen, ist die Ellipsometrie oftmals zu langsam, besonders bei den hier angestrebten hohen Rotatiofrequenzen. Daher kann hier sehr vorteilhaft die Messung der Rp und Rs Komponenten (bzw. Tp und Ts) eingesetzt werden. Die Messung kann hierbei unter 45° Einfallswinkel erfolgen, wobei ein statisch angeordneter Polarisator eingesetzt wird. Für zwei Polarisationen können zwei Strahlengänge verwendet werden.

Alternativ kann auch eine Komponente der Polarisation ausgesucht werden und das Spektrum mit dem unter senkrechter Inzidenz gemessenen Transmission kombiniert werden. Somit wird die gleiche kurze Messzeit (im msec-Bereich) erreicht wie bei der Transmissionsmessung.

Die Kombination der Messung mit polarisiertem Licht ist auch besonders geeignet, um dünne metallische Schichten zu kontrollieren (z.B. Silber oder Aluminium), die beispielsweise bei polarisierenden Strahlteilern eingesetzt werden.

In einer weiteren bevorzugten Ausgestaltung der Vorrichtung weist die Substrathalterung des Drehtellers Polyetheretherketon auf oder besteht daraus. Die Verwendung von Polyetheretherketon hat den Vorteil, dass die Partikelbildung vermindert wird.

Anhand der nachfolgenden Figuren und Beispiele soll der erfindungsgemäße Gegenstand näher erläutert werden, ohne diesen auf die hier gezeigten speziellen Ausführungsformen einschränken zu wollen.
Fig. 1 zeigt eine Skizze einer bevorzugten erfindungsgemäßen Vorrichtung ohne Drehteller in der Draufsicht.
Fig. 2 zeigt eine Skizze einer bevorzugten erfindungsgemäßen Vorrichtung mit Drehteller in der Draufsicht.
Fig. 3 zeigt eine Skizze einer bevorzugten erfindungsgemäßen Vorrichtung mit Drehteller in der Seitenansicht.

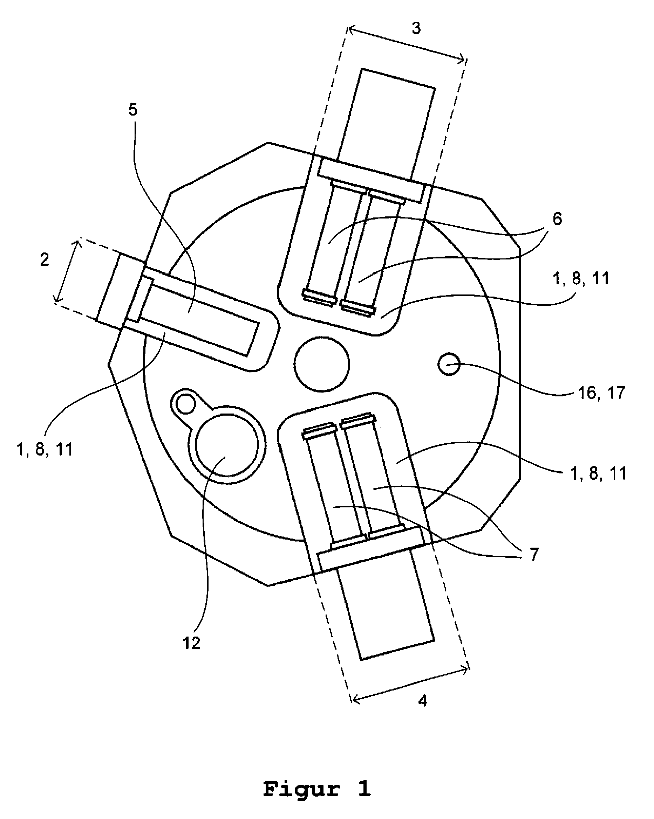

Figur 1 zeigt schematisch in der Draufsicht eine bevorzugte erfindungsgemäße Vorrichtung ohne Drehteller. Die Vorrichtung weist drei Magnetron-Sputtereinrichtungen 2, 3, 4 auf, wovon eine in der Einzelmagnetronanordung 2 und zwei in der Doppelmagnetronanordnung 3, 4 ausgestaltet sind. Die Magnetron-Sputtereinrichtungen 2 enthält eine Magnetron-Elektrode 5, Sputtergas 11, optional Reaktivgas 8 und befindet sich im Vakuum 1. Die Magnetron-Sputtereinrichtungen 3, 4 enthalten jeweils zwei Magnetron-Elektroden 6, 7, Sputtergas 11, optional Reaktivgas 8 und befinden sich im Vakuum 1. In der Nachbarschaft der Magnetron-Sputtereinrichtungen 2, 3, 4 befindet sich eine Plasmaquelle 12 und ein Photometer 16 und/oder eine Ellipsometrieflansche 17.

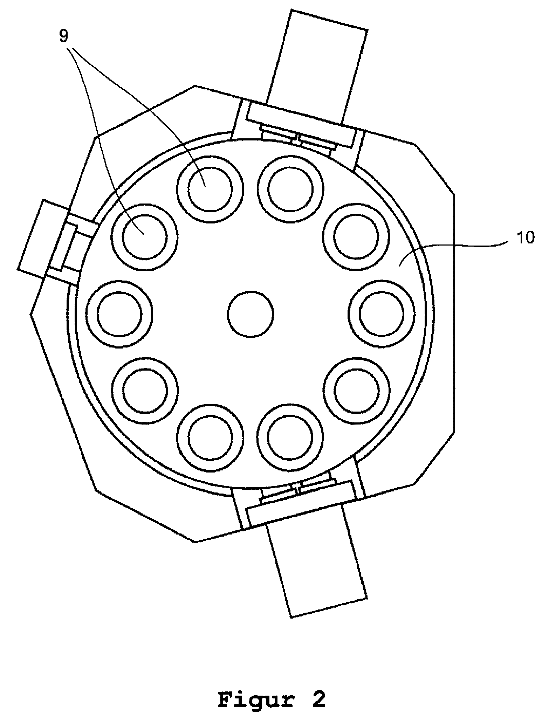

Figur 2 zeigt schematisch in der Draufsicht eine bevorzugte Ausgestaltung des Drehtellers. Der Drehteller 10 befindet sich in der Vorrichtung und weist in diesem Beispiel zehn identische Substrathalterungen 9 auf.

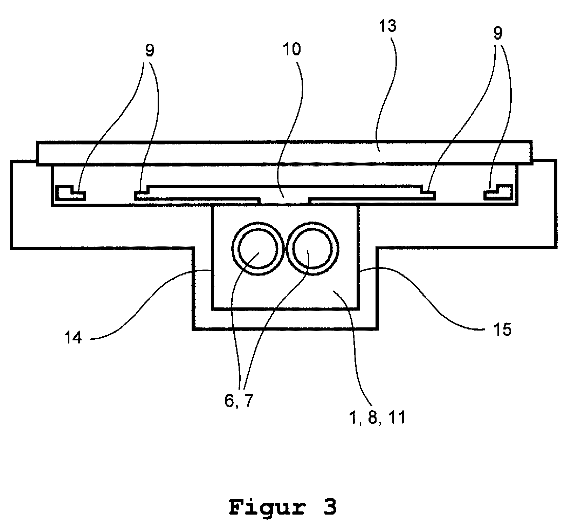

Figur 3 zeigt schematisch in der Seitenansicht eine bevorzugte Ausgestaltungsform der Vorrichtung mit Drehteller 10. Es ist der Querschnitt einer Magnetron-Sputtereinrichtung sichtbar, welche zwei Zylinder aus Quellmaterial 6, 7 enthält (Doppelmagnetronanardnung). Die Magnetron-Sputtereinrichtung ist an den Seiten von Begrenzungswänden 14, 15 und oben durch den Drehteller 10 gasdicht vom Rest der Vorrichtung abgegrenzt, enthält Sputtergas 11, optional Reaktivgas 8, und ist unter Vakuum 1. zwei Substrathalterungen 9 des Drehtellers 10 sind in dem Querschnitt dargestellt bzw. sichtbar. Oberhalb des Drehtellers 10 befindet sich ein Deckel 13, welcher mit Begrenzungswänden, welche sich seitlich des Drehtellers 10 befinden, die Vorrichtung gasdicht abschließt.

## Patentansprüche

1. Verfahren zur Herstellung partikelarmer Schichten auf bewegten Substraten in einer Vakuumkammer (1) mittels mindestens einer Magnetron-Sputtereinrichtung (2, 3, 4), wobei die Schichten aus zylindrischem Quellmaterial mindestens einer Magnetron-Elektrode (5, 6, 7) gebildet werden, **dadurch gekennzeichnet, dass** folgende Schritte vorgesehen sind:
- Immobilisieren des Substrates mittels einer Substrathalterung (9) auf einem Drehteller (10);
- Abscheiden mindestens einer Schicht aus Quellmaterial (5, 6, 7) mit Sputtergas (11) auf dem Substrat in mindestens einer Magnetron-Sputtereinrichtung (2, 3, 4); und
wobei der Drehteller (10) rotiert, so dass die Magnetron-Sputtereinrichtung (2, 3,4) angesteuert werden kann und das zylindrische Quellmaterial der Magnetron-Elektrode (5, 6, 7) nach oben entgegen der Schwerkraft auf das Substrat abgeschieden wird und wobei der Prozessdruck in der Magnetron-Sputtereinrichtung (2, 3, 4) in dem Bereich von 3·10⁻⁴ bis 5·10⁻² mbar liegt und wobei der Partialdruck des Sputtergases (11) in der Magnetron-Sputtereinrichtung (2, 3, 4) über einen Generator geregelt und/oder stabilisiert wird und wobei die Magnetron-Elektrode (5, 6, 7) ein Target enthaltend oder bestehend aus einem keramischen Material enthält oder daraus besteht.

2. Verfahren gemäß dem vorhergehenden Anspruch, **dadurch gekennzeichnet, dass** in dem Verfahren mindestens eine Plasmaquelle (12) verwendet wird, wobei die mindestens eine Plasmaquelle (12) vorzugsweise die Oberfläche des Substrates über Plasmaeinwirkung vorbehandelt und/oder die mindestens eine Plasmaquelle (12) vorzugsweise die Struktur und/oder die Stöchiometrie der Schicht über Plasmaeinwirkung modifiziert.

3. Verfahren gemäß Anspruch 2, **dadurch gekennzeichnet, dass** die mindestens eine Plasmaquelle (12) über einen Drehteller (10) angesteuert wird.

4. Verfahren gemäß einem der vorhergehenden Ansprüche, **dadurch gekennzeichnet, dass** der Partialdruck des Sputtergases (11) und/oder des Reaktivgases (8) in der Magnetron-Sputtereinrichtung (2, 3, 4) über Regelung der Generatorleistung, der Generatorspannung und/oder des Generatorstroms geregelt und/oder stabilisiert wird.

5. Verfahren gemäß einem der vorhergehenden Ansprüche, **dadurch gekennzeichnet, dass** zur Prozesskontrolle die Dicke der Schicht auf dem Substrat kontrolliert wird durch
a) optisches Transmissionsmonitoring;
b) optisches Reflexionsmonitoring;
c) optisches Absorptionsmonitoring;
d) Einwellenlängenellipsometrie oder Spektralellipsometrie; und/oder
e) Schwingquarzmessung.

6. Verfahren gemäß dem einem der vorhergehenden Ansprüche, **dadurch gekennzeichnet, dass** die Temperatur eines beheizbaren Elements an dem Deckel (13) in Abhängigkeit von der herzustellenden Schicht eingestellt wird und/oder während des Beschichtungsprozesses verändert wird.

7. Vorrichtung zur Herstellung partikelarmer Schichten auf mindestens einem bewegten Substrat im Vakuum mittels Magnetronzerstäubung, umfassend
a) mindestens eine Magnetron-Sputtereinrichtung (2, 3, 4) mit mindestens einer Magnetron-Elektrode (5, 6, 7) aus zylindrischem Quellmaterial, einem Generator, Sputtergas (11);
b) einen Deckel (13);
c) einen Drehteller (10) mit mindestens einer Substrathalterung (9);
wobei der Deckel (13) die Vorrichtung gasdicht abschließt und der Drehteller (10) die Magnetron-Sputtereinrichtung (2, 3,4) gasdicht abschließt, **dadurch gekennzeichnet, dass** die Magnetron-Sputtereinrichtung (2, 3, 4) so ausgerichtet ist, dass sie Material der MagnetronElektrode (5, 6, 7) gegen die Schwerkraft in Richtung Substrat abscheidet und der Prozessdruck in der Magnetron-Sputtereinrichtung (2, 3, 4) in dem Bereich von 3·10⁻⁴ bis 5·10⁻² mbar liegt, wobei der Partialdruck des Sputtergases (11) in der Magnetron-Sputtereinrichtung (2, 3, 4) über den Generator geregelt und/oder stabilisiert werden kann, und wobei die Magnetron-Elektrode (5, 6, 7) ein Target enthaltend oder bestehend aus einem keramischen Material enthält oder daraus besteht.

8. Vorrichtung gemäß Anspruch 7, **dadurch gekennzeichnet, dass** die Vorrichtung mindestens eine Plasmaquelle (12) enthält.

9. Vorrichtung gemäß einem der Ansprüche 7 oder 8, **dadurch gekennzeichnet, dass** der Drehteller (10) oberhalb der Magnetron-Sputtereinrichtung (2, 3, 4) lokalisiert ist.

10. Vorrichtung gemäß einem der Ansprüche 7 bis 9, **dadurch gekennzeichnet, dass** die Magnetron-Elektrode (5, 6, 7) ein Target enthaltend oder bestehend aus Mischungen aus einem
keramischem Material und einem
a) thermisch gespritztem Material oder Materialmischungen;
b) kristallinem Material;
c) metallischem Material oder Materialmischungen; und/oder
d) einem Oxid-haltigen Material,
enthält oder daraus besteht, wobei das Substrat zu der Magnetron-Elektrode (5, 6, 7) vorzugsweise einen Abstand von 2 bis 10 cm aufweist und/oder der Abstand zwischen Drehteller (10) und Begrenzungswänden (14, 15) der Magnetron-Sputtereinrichtung (2, 3, 4) 0,1 bis 5 mm beträgt

11. Vorrichtung gemäß einem der Ansprüche 7 bis 10, **dadurch gekennzeichnet, dass** die Vorrichtung zwei oder drei Magnetron-Sputtereinrichtungen (2, 3, 4) aufweist, wobei die Magnetron-Sputtereinrichtung (2, 3, 4) bevorzugt in einer Einzelmagnetronanordnung (2) oder in einer Doppelmagnetronanordnung (3, 4) ausgestaltet ist und wobei die Magnetron-Sputtereinrichtung (2, 3, 4) innerhalb des Vakuums eine effektive Gasraumtrennung für Gase von 1:25 aufweist.

12. Vorrichtung gemäß einem der Ansprüche 7 bis 11, **dadurch gekennzeichnet, dass** das Sputtergas (11) ein Edelgas enthält und/oder daraus besteht und/oder das Reaktivgas (8) ein Gas der Gruppe bestehend aus Sauerstoff, Stickstoff, Tetrafluormethan, Octafluorcyclobutan, Kohlendioxid und Fluorwasserstoff enthält oder daraus besteht.

13. Vorrichtung gemäß einem der Ansprüche 7 bis 12, **dadurch gekennzeichnet, dass** die Vorrichtung ein Photometer (16), eine Ellipsometrieflansche (17) und/oder ein Bauelement, welches eine Polarisationswirkung ausübt, enthält.

14. Vorrichtung gemäß einem der Ansprüche 7 bis 13, **dadurch gekennzeichnet, dass** die Substrathalterung (9) des Drehtellers (10) Polyetheretherketon aufweist oder daraus besteht.

## Claims

1. Method for producing low-particle layers on moved substrates in a vacuum chamber (1) by means of at least one magnetron sputtering device (2, 3, 4), wherein the layers are formed from cylindrical source material of at least one magnetron electrode (5, 6, 7), **characterised in that** the following steps are provided:
- immobilising the substrate by means of a substrate holder (9) on a rotary plate (10);
- depositing at least one layer made from source material (5, 6, 7) with sputter gas (11) on the substrate in at least one magnetron sputtering device (2, 3, 4); and
wherein the rotary plate (10) rotates such that the magnetron sputtering device (2, 3, 4) can be controlled and the cylindrical source material of the magnetron electrode (5, 6, 7) is deposited onto the substrate upwards against gravity and wherein the process pressure in the magnetron sputtering device (2, 3, 4) ranges from 3·10⁻⁴ to 5·10⁻² mbar and wherein the partial pressure of the sputter gas (11) in the magnetron sputtering device (2, 3, 4) is regulated and/or stabilised via a generator and wherein the magnetron electrode (5, 6, 7) contains or consists of a target containing or consisting of a ceramic material.

2. Method according to the preceding claim, **characterised in that**, in the method, at least one plasma source (12) is used, wherein the at least one plasma source (12) preferably pretreats the surface of the substrate via the effect of plasma and/or the at least one plasma source (12) preferably modifies the structure and/or the stoichiometry of the layer via the effect of plasma.

3. Method according to claim 2, **characterised in that** the at least one plasma source (12) is controlled via a rotary plate (10).

4. Method according to one of the preceding claims, **characterised in that** the partial pressure of the sputter gas (11) and/or of the reactive gas (8) in the magnetron sputtering device (2, 3, 4) is regulated and/or stabilised via regulation of the generator power, the generator voltage and/or the generator current.

5. Method according to one of the preceding claims, **characterised in that**, for the process control, the thickness of the layer on the substrate is controlled by
a) optical transmission monitoring;
b) optical reflection monitoring;
c) optical absorption monitoring;
d) single wavelength ellipsometry or spectral ellipsometry; and/or
e) piezoelectric crystal measurement.

6. Method according to one of the preceding claims, **characterised in that** the temperature of a heatable element on the cover (13) is adjusted depending on the layer to be produced and/or is changed during the coating process.

7. Device for producing low-particle layers on at least one moved substrate in the vacuum by means of magnetron atomisation comprising
a) at least one magnetron sputtering device (2, 3, 4) having at least one magnetron electrode (5, 6, 7) made from cylindrical source material, a generator, sputter gas (11) ;
b) a cover (13);
c) a rotary plate (10) having at least one substrate holder (9);
wherein the cover (13) closes the device in a gas-tight manner and the rotary plate (10) closes the magnetron sputtering device (2, 3, 4) in a gas-tight manner, **characterised in that** the magnetron sputtering device (2, 3, 4) is aligned such that the material of the magnetron electrode (5, 6, 7) deposits in the direction of the substrate against gravity and the process pressure in the magnetron sputtering device (2, 3, 4) ranges from 3·10⁻⁴ to 5·10⁻² mbar, wherein the partial pressure of the sputter gas (11) in the magnetron sputtering device (2, 3, 4) can be regulated and/or stabilised via the generator, and wherein the magnetron electrode (5, 6, 7) contains or consists of a target containing or consisting of a ceramic material.

8. Device according to claim 7, **characterised in that** the device contains at least one plasma source (12).

9. Device according to one of claims 7 or 8, **characterised in that** the rotary plate (10) is located above the magnetron sputtering device (2, 3, 4).

10. Device according to one of claims 7 to 9, **characterised in that** the magnetron electrode (5, 6, 7) contains or consists of a target containing or consisting of mixtures of a ceramic material and a
a) thermally sprayed material or material mixtures;
b) crystalline material;
c) metallic material or material mixtures; and/or
d) material containing an oxide,
wherein the substrate preferably has a distance of 2 to 10cm to the magnetron electrode (5, 6, 7) and/or the distance between the rotary plate (10) and the limiting walls (14, 15) of the magnetron sputtering device (2, 3, 4) is to 0.1 to 5mm.

11. Device according to one of claims 7 to 10, **characterised in that** the device has two or three magnetron sputtering devices (2, 3, 4), wherein the magnetron sputtering device (2, 3, 4) is preferably designed in a single magnetron arrangement (2) or in a double magnetron arrangement (3, 4), and wherein the magnetron sputtering device (2, 3, 4) within the vacuum has an effective gas compartment separation for gases of 1:25.

12. Device according to one of claims 7 to 11, **characterised in that** the sputter gas (11) contains and/or consists of a noble gas and/or the reactive gas (8) contains or consists of a gas of the group consisting of oxygen, nitrogen, tetrafluoromethane, octafluorocyclobutane, carbon dioxide and hydrogen fluoride.

13. Device according to one of claims 7 to 12, **characterised in that** the device contains a photometer (16), a ellipsometry flange (17) and/or a component which exerts a polarisation effect.

14. Device according to one of claims 7 to 13, **characterised in that** the substrate holder (9) of the rotary plate (10) comprises or consists of polyether ether ketone.

## Revendications

1. Procédé de fabrication de couches pauvres en particules sur des substrats déplacés dans une chambre à vide (1) au moyen d'au moins un dispositif de pulvérisation à magnétron (2, 3, 4), les couches étant constituées d'un matériau source cylindrique d'au moins une électrode de magnétron (5, 6, 7), **caractérisé en ce que** les étapes suivantes sont prévues :
- immobilisation du substrat au moyen d'un support de substrat (9) sur un plateau rotatif (10) ;
- dépôt d'au moins une couche de matériau source (5, 6, 7) avec un gaz de pulvérisation (11) sur le substrat dans au moins un dispositif de pulvérisation à magnétron (2, 3, 4) ; et
le plateau rotatif (10) tournant, de façon à ce que le dispositif de pulvérisation à magnétron (2, 3, 4) puisse être contrôlé et à ce que le matériau source cylindrique de l'électrode de magnétron (5, 6, 7) soit déposé vers le haut à l'encontre de la force de gravité sur le substrat et la pression du processus dans le dispositif de pulvérisation à magnétron (2, 3, 4) étant de l'ordre de 3.10⁻⁴ à 5.10⁻² mbar et la pression partielle du gaz de pulvérisation (11) dans le dispositif de pulvérisation à magnétron (2, 3, 4) étant régulé et/ou stabilisé à l'aide d'un générateur et l'électrode de magnétron (5, 6, 7) contenant une cible contenant ou constituée d'un matériau céramique ou étant constituée de celle-ci.

2. Procédé selon la revendication précédente, **caractérisé en ce que**, dans le procédé, au moins une source de plasma (12) est utilisée, l'au moins une source de plasma (12) pré-traitant de préférence la surface du substrat grâce à l'action du plasma et/ou l'au moins une source de plasma (12) modifiant de préférence la structure et/ou la stoechiométrie de la couche grâce à l'action du plasma.

3. Procédé selon la revendication 2, **caractérisé en ce que** l'au moins une source de plasma (12) est contrôlée par l'intermédiaire d'un plateau rotatif (10).

4. Procédé selon l'une des revendications précédentes, **caractérisé en ce que** la pression partielle du gaz de pulvérisation (11) et/ou du gaz réactif (8) dans le dispositif de pulvérisation à magnétron (2, 3, 4) est régulée et/ou stabilisée par la régulation de la puissance du générateur, de la tension du générateur et/ou du courant du générateur.

5. Procédé selon l'une des revendications précédentes, **caractérisé en ce que**, pour le contrôle du processus, l'épaisseur de la couche sur le substrat est contrôlée par :
a) surveillance de transmission optique ;
b) surveillance de réflexion optique ;
c) surveillance d'absorption optique ;
d) ellipsométrie à une longueur d'onde ou ellipsométrie spectrale ; et/ou
e) mesure par quartz oscillant.

6. Procédé selon l'une des revendications précédentes, **caractérisé en ce que** la température d'un élément chauffable au niveau du couvercle (13) est réglée en fonction de la couche à réaliser et/ou est modifiée pendant le processus de revêtement.

7. Dispositif de fabrication de couches pauvres en particules sur au moins un substrat déplacé dans le vide au moyen d'une pulvérisation par magnétron, comprenant :
a) au moins un dispositif de pulvérisation à magnétron (2, 3, 4) avec au moins une électrode de magnétron (5, 6, 7) constituée d'un matériau source cylindrique, d'un générateur, d'un gaz de pulvérisation (11) ;
b) un couvercle (13) ;
c) un plateau rotatif (10) avec au moins un support de substrat (9) ;
le couvercle (13) fermant le dispositif de manière étanche aux gaz et le plateau rotatif (10) fermant le dispositif de pulvérisation à magnétron (2, 3, 4) de manière étanche aux gaz, **caractérisé en ce que** le dispositif de pulvérisation à magnétron (2, 3, 4) est orienté de façon à déposer le matériau de l'électrode de magnétron (5, 6, 7) à l'encontre de la force de gravité en direction du substrat et la pression du processus dans le dispositif de pulvérisation à magnétron (2, 3, 4) est de l'ordre de 3.10⁻⁴ à 5.10⁻² mbar, la pression partielle du gaz de pulvérisation (11) dans le dispositif de pulvérisation à magnétron (2, 3, 4) pouvant être régulée et/ou stabilisée par l'intermédiaire du générateur et l'électrode de magnétron (5, 6, 7) contenant une cible contenant ou constituée d'un matériau céramique ou étant constituée de celle-ci.

8. Dispositif selon la revendication 7, **caractérisé en ce que** le dispositif comprend au moins une source de plasma (12).

9. Dispositif selon l'une des revendications 7 ou 8, **caractérisé en ce que** le plateau rotatif (10) est disposé au-dessus du dispositif de pulvérisation à magnétron (2, 3, 4).

10. Dispositif selon l'une des revendications 7 à 9, **caractérisé en ce que** l'électrode de magnétron (5, 6, 7) contient ou est constituée d'une cible contenant ou constituée de mélanges constitués d'un matériau céramique et
a) d'un matériau ou de mélanges de matériaux injectés thermiquement ;
b) d'un matériau cristallin ;
c) d'un matériau ou de mélanges de matériaux métalliques ; et/ou
d) d'un matériau contenant un oxyde,
le substrat présentant, par rapport à l'électrode de magnétron (5, 6, 7), de préférence une distance de 2 à 10 cm et/ou la distance entre le plateau rotatif (10) et les parois de limitation (14, 15) du dispositif de pulvérisation à magnétron (2, 3, 4) est de 0,1 à 5 mm.

11. Dispositif selon l'une des revendications 7 à 10, **caractérisé en ce que** le dispositif comprend deux ou trois dispositifs de pulvérisation à magnétrons (2, 3, 4), le dispositif de pulvérisation à magnétron (2, 3, 4) étant conçu de préférence sous la forme d'un dispositif à un seul magnétron (2) ou d'un dispositif à double magnétron (3, 4) et le dispositif de pulvérisation à magnétron (2, 3, 4) présentant, à l'intérieur du vide, une séparation effective pour les gaz de 1:25.

12. Dispositif selon l'une des revendications 7 à 11, **caractérisé en ce que** le gaz de pulvérisation (11) contient un gaz noble et/ou est constitué de celui-ci et/ou le gaz réactif (8) contient ou est constitué d'un gaz du groupe constitué de l'oxygène, de l'azote, du tétrafluorométhane, de l'octafluorocyclobutane, du dioxyde de carbone et du fluorure d'hydrogène.

13. Dispositif selon l'une des revendications 7 à 12, **caractérisé en ce que** le dispositif comprend un photomètre (16), une bride d'ellipsométrie (17) et/ou un composant qui exerce une action de polarisation.

14. Dispositif selon l'une des revendications 7 à 13, **caractérisé en ce que** le support de substrat (9) du plateau rotatif (10) comprend ou est constitué de polyétheréthercétone.
